# EUROPEAN PATENT SPECIFICATION

(11) **EP 0 893 515 B1**
(45) Date of publication and mention of the grant of the patent: **26.11.2003**
(21) Application number: 98111849.0
(22) Date of filing: 26.06.1998
(51) Int. Cl.: C30B 29/30, C30B 33/00

(54) **Preconditioned crystals of lithium niobate and lithium tantalate and methods of preparing the same**
Vorbehandelte Kristalle aus Lithiumniobat und Lithiumtantalat und das Verfahren zu ihrer Herstellung
CRISTAUX PRETRAITES DE NIOBATE DE LITHIUM ET DE TANTALATE DE LITHIUM ET METHODES POUR LEUR PREPARATION

(30) Priority: 25.07.1997 US 900179
(43) Date of publication of application: 27.01.1999
(73) Proprietor: CRYSTAL TECHNOLOGY, INC., Palo Alto, CA 94303 (US)
(72) Inventor: Bordui, Peter Frank, Palo Alto, CA 94306 (US); Norwood, Richard Gregory, San Jose, CA 95138 (US); Jundt, Dieter Hans, Sunnyvale, CA 94087 (US); Standifer, Eugene Michael, Sunnyvale, CA 94086 (US)
(74) Representative: Epping Hermann & Fischer

(56) References cited:
- EP-A- 0 191 671
- EP-A- 0 615 005
- PATENT ABSTRACTS OF JAPAN vol. 18, no. 642 (P-1838), 6 December 1994 & JP 06 250399 A (FUJI ELECTROCHEM CO LTD), 9 September 1994
- DHAR: "Optical properties of reduced lithium niobate single crystals" JOURNAL OF APPLIED PHYSICS., vol. 68, no. 11, 1 December 1990, pages 5804-5809, XP000207962 NEW YORK US

## Description

### Field of the Invention

The present invention relates to improved crystals of lithium niobate and lithium tantalate and methods of preconditioning such crystals for use in electrical applications such as surface acoustic wave filter devices.

### Background of the Invention

Lithium niobate (LN) and lithium tantalate (LT) are widely used in a variety of electronic applications including surface acoustic wave (SAW) signal processing, guided-wave optic modulation and switching, and electro-optic laser Q-switching, and modulation. The physical basis for the suitability of LN and LT crystals for these types of applications is their atomic-scale crystal structure, which results in the crystals' natural piezoelectric response useful in SAW-based devices, electro-optic response useful in integrated optic devices and pyroelectric response useful in pyroelectric detectors. Another characteristic of LN and LT that may be important in some applications is the optical absorption of the crystal. For example, integrated optic devices require a relatively small optical absorption, while other devices, such as SAW filters do not require a low optical absorption. In some instances, this natural physical response of the crystals can complicate crystal processing and adversely effect performance of devices in which the crystals are incorporated.

A crystal's pyroelectric or piezoelectric response causes the external surfaces of a fabricated crystal to become electrically charged in response to a change in temperature of the crystal or in response to a mechanical stress applied to the crystal. These electrical surface charges can spontaneously short, with associated sparking causing dramatic processing or performance failure, or even crystal fracture. One common example of such performance failure is an unacceptably high bit-error-rate of LN-based SAW filters used in digital radio applications. In order to avoid such types of failures, current production protocols for these types of filters include extensive and costly device testing designed to eliminate those filters prone to such spurious pyroelectric or piezoelectric induced failures.

The process of incorporating LN or LT crystals into electronic devices often includes steps that result in exposing the crystals to conditions that invoke an untimely and unwanted pyroelectric or piezoelectric response. In an effort to reduce the risk of problems associated with the unintended build up of surface charges, for example catastrophic discharge of these charges during manufacture, device manufacturers have had to cake steps that add significantly to the cost, time, and complexity of incorporating the crystals into devices.

For LN and LT crystals manufactured by conventional methods, surface charges can eventually decay with time as they are neutralized by the movement of free charge from within the crystal itself or from the surrounding environment. This natural decay occurs after the surface charge develops and does nothing to mitigate or minimize the degree to which the surface of the crystal becomes charged as a result of the crystal's natural piezoelectric or pyroelectric response.

In view of the increasing demand for reliable LN and LT crystals for applications such as surface acoustic wave filter devices, guided wave optic modulation and switching, and electro-optic Q-switching and modulation, the need exists for LN and LT crystals that continue to exhibit properties that make them desirable for such applications and that do not suffer from the drawbacks associated with the buildup of excessive spurious pyroelectric or piezoelectric surface charges.

### Summary of the Invention

In accordance with the present invention, crystals of LN or LT are preconditioned to increase the ability of the crystal to reduce electrical charging of the crystal surface. Crystals of the present invention are able to reduce electrical charging by effectively reducing or dissipating the buildup of surface electric charges (caused by the natural pyroelectric or piezoelectric response of the crystal) preferably as fast as the charges are generated.

The present invention also relates to a method for preconditioning or an LN or LT crystal to increase the crystal's ability to reduce electric charging of the crystal's surface. In a preferred embodiment of the method aspect of the present invention, the ability of the crystal to reduce electric charging of the crystal's surface is increased by exposing the crystal to a combination of heat and a chemically reducing atmosphere to increase the free electron density within the crystal.

The present invention provides crystals which can effectively minimize the buildup of electric charges on the crystal surface that are induced by the crystal's natural pyroelectric or piezoelectric response, particularly those surface charges that build up as a result of mechanical stress or temperature change not associated with the normal operation of the device in which the crystal is incorporated. In a preferred embodiment, the preconditioned crystal is able to reduce surface charging by neutralizing or dissipating these charges as fast as they are generated.

### Detailed Description of the Preferred Embodiment

The LN (the compound formed from Li₂O and Nb₂O₅) and LT (the compound formed from Li₂O and Ta₂O₅) crystals of the present invention exhibit piezoelectric and pyroelectric responses that make the crystals suitable for applications such as surface acoustic wave (SAW) signal processing, guided-wave optic modulation and switching, and electro-optic laser Q-switching and modulation. The present invention is described below in the context of LN crystals; however, the description is believed to be equally applicable to other types of crystals such as LT.

LN and LT crystals can be grown by a number of techniques, the most well-known of which is the Czochralski technique. A summary of the Czochralski technique can be found in Current Topics and Material Science, Vol. 1, E. Kaldis editor, North Holland Publishing Co., 1978, ch. 7 by Dr. Armin Räuber, p. 545-48, which is herein incorporated by reference. LN crystals grown by the Czochralski technique are achieved by pulling LN from a melt. Nearly any kind of conventional crystal pulling apparatus can be used. The crucible in which the LN is heated can be platinum. There are no special demands for the atmosphere, with air in many situations being preferred.

As noted in the background of the invention, LN crystals exhibit a natural piezoelectric and pyroelectric response. As a result, as illustrated in the Comparative Example set forth below, LN crystals in the form of wafers build up surface charges when subjected to a temperature change, such as those encountered when such crystals are processed and incorporated into electrical devices, or when the devices are used. These surface charges, which can take extended periods of time (e.g., 15-20 hours) to dissipate naturally, can cause sparking or shorting which can lead to device malfunction or failure or even crystal fracture. In contrast, as described in the Example that follows the Comparative Example, preconditioned LN wafers of the present invention are able to effectively reduce the buildup of at least a portion of surface charges resulting from the crystal's natural pyroelectric response. By effectively reducing surface charging, (1) the risk of sparking is reduced, and the risk of device failure can be reduced; and (2) the need for costly and time intensive processing steps normally used to reduce the buildup of surface charging is avoided.

While not intended to be limited to any particular theory, it is believed that the observed reduction in surface charging for preconditioned crystals of the present invention is a result of the increased electrical conductivity of the preconditioned crystals compared to crystals that have not been preconditioned. Preferably, the crystal's electrical conductivity is increased without a significant change in other physical and electrical properties that make the crystal desirable for its intended purpose. A preferred process for preconditioning LN crystals is described below. Other techniques capable of increasing the electronic conductivity of the crystal without adversely affecting the other physical and electrical properties of the crystal can also be used to increase the ability of a LN or LT crystal to reduce surface charging in accordance with the present invention. The specific process described below is preferred, due to its simplicity and ease of control.

LN or LT crystals of the present invention have been treated to increase the crystal's ability to neutralize or dissipate electrical charges on the crystal surface. Preconditioned crystals that have been preconditioned using the method of a preferred embodiment, unlike crystals that have not been preconditioned, exhibit a color ranging from light grey to dark blue or black. The crystals may be lightly colored or they may be opaque, depending on the conditions that are used to precondition the crystal. In view of this color change, the preconditioned crystals of the preferred embodiment are preferred for applications where optical absorption is not a critical crystal property. The preconditioned crystals, after being exposed to conditions that invoke a pyroelectric response, exhibit a surface charge that is less than the surface charge that is observed from crystals exposed to the same conditions that have not been preconditioned according to the present invention. In certain situations, as described below in the Example, preconditioned crystals of the preferred embodiment do not exhibit any measurable pyroelectric charge after being exposed to a temperature change that normally invokes a pyroelectric response that results in the formation of a measurable surface charge.

One process for preconditioning an LN crystal in accordance with the present invention involves exposing wafers of LN crystals to heat under a chemically reducing atmosphere. After the wafers are exposed to the desired temperature, they are allowed to cool back to room temperature. Suitable preconditioning of LN crystal wafers can be achieved by exposing the wafers to target temperatures in an oven greater than about 500°C under an 85% nitrogen gas and 15% hydrogen gas atmosphere for dwell times on the order of about one to about 200 minutes. After the wafers have been exposed to the target temperature, they can be cooled to room temperature.

As illustrated in the Example that follows, the preconditioned crystal wafers that have been exposed to conditions that invoke a pyroelectric response exhibit surface charges that are less than the surface charges that build up on identical wafers that have been exposed to the same conditions but have not been preconditioned in accordance with the present invention. In addition, when a detectable surface charge is observed, the length of time required for the surface charge to decay below detectable levels using a conventional electrostatic field meter is less for preconditioned crystals compared to crystal wafers that have not been preconditioned.

In addition to those described above and in the Example that follows, other target temperatures, heat up and cool down rates, dwell times and atmospheres suitable for increasing the ability of the crystal to reduce surface charging without adversely affecting the desirable performance properties of the crystal can be employed. For example, in addition to the hydrogen and nitrogen gas mixture described below, other gases such as hydrogen alone, nitrogen alone, argon, water, carbon dioxide, carbon monoxide, oxygen, and combinations thereof can be used in accordance with the present invention. A combination of 85% nitrogen gas and 15% hydrogen gas is preferred because of its ready availability from numerous commercial sources. It is contemplated that different gas mixtures will provide different results so far as the extent of the reduction that is achieved.

The rate at which the crystal wafers are heated is not believed to be critical. Effective preconditioning of LN crystals can be achieved at heat up rates of about 6°C to about 7°C per minute. Likewise, the cool down rate is not believed to be critical and effective preconditioning of LN crystals can be achieved at cool down rates ranging from about 0.5°C to about 1°C per minute. Other heating rates and cooling rates that are either greater or less than those set forth above may also be used.

Effective preconditioning is achieved at oven temperatures above 500°C. Preferably, the oven temperature ranges from about 500°C to up to about 1,140°C (the Curie temperature for lithium niobate) and most preferably from about 750°C up to about 1,140°C. The higher temperatures are preferred because they provide a greater increase in the ability of the crystal to reduce surface charging compared to temperatures near the lower end of the ranges. For oven temperatures closer to the lower end of the ranges noted above, an increase in the ability of the crystal to reduce surface charging is observed, but the increase is not as great compared to the increase observed at the higher temperatures. An increase in the ability of the crystals to reduce surface charging is also observed at temperatures below about 500°C although such increases are less than those observed at temperatures greater than 500°C. As discussed above, depending upon the effect of the preconditioning on other properties of the crystal, the lower temperatures may be suitable and in fact preferred.

The dwell times that the crystals are exposed to the target temperature in accordance with the present invention can vary. Increasing the dwell times for a given target temperature and atmosphere should increase the ability of a crystal to reduce surface charge build up compared to crystals exposed to the target temperature for shorter dwell times. Shorter dwell times are preferred from the standpoint of minimizing process times and energy requirements for the process.

As set forth in more detail below in the Comparative Example and the Example that follows, preconditioned LN crystal wafers of the present invention that have been exposed to conditions that invoke a natural pyroelectric response, exhibit surface charges that are less than the surface charges observed on conventional LN wafers that have not been preconditioned and have been exposed to the same conditions.

### Comparative Example

This comparative example illustrates the natural pyroelectric response of a conventional LN crystal that has not been preconditioned in accordance with the present invention.

A wafer of LN 76 mm in diameter and 0.5 mm thick oriented with the surface normal to the 64° rotated y-direction was prepared using the Czochralski method and a conventional fabrication method. The wafer was polished on one side and was colorless and translucent. The wafer was electrically neutralized on a hot plate at 125°C. Following electrical neutralization, the wafer was cooled to 80°C over 45 minutes and held at 80°C using the same hot plate. Using a laboratory electrostatic field meter available under the trademark Digital Stat-Arc 2, Model No. 282-1 from Monroe Electronics, the wafer surface was measured to have a charge of at least 5 x 10⁻⁹ coulombs based on the total surface area of the wafer. The surface charge was monitored continuously and recorded every five minutes. After roughly about one hour at 80°C the surface charge was remeasured and observed to decay slowly to approximately 60 percent of the original surface charge. It was only after an extended period of about 15 hours at 80°C, that the total surface charge was observed to dissipate to a level below 5 x 10⁻¹¹ coulombs based on the total surface area of the wafer at 80°C, the detection limit of the electrostatic field meter.

In this comparative example the surface charge and its decay was observed at 80°C. At room temperature the length of time needed to allow the surface charge to decay below detectable limits would be even longer.

This comparative example illustrates the surface charging of an LN wafer resulting from the natural pyroelectric response of LN and the length of time needed to naturally dissipate the built-up charge.

### Example

In this example, LN wafers are preconditioned to increase their ability to reduce surface charging in accordance with the present invention.

Wafers of LN were cut from the same boule that served as the source of the wafer in the Comparative Example. The wafers were polished and lapped in an identical manner as the wafer described in the Comparative Example. These wafers were placed in a sealed oven through which a mixture of 85% nitrogen gas and 15% hydrogen gas was flowed at a rate of approximately 1.5 liters per minute. The oven comprised a three-zone tube furnace with a horizontal, 4-inch diameter alumina process tube. The wafers were supported by alumina carriers placed in the center of the process tube. The alumina process tube extended out of the furnace so that its ends were exposed and remained cool. O-ring seals on the alumina process tube provided a sealed furnace cavity. The wafer was loaded into the process tube which was then sealed with end caps. The gas flow was initiated and the furnace heating schedule begun. The furnace temperature was increased from room temperature to the target temperature at a rate of about 6.7°C per minute. Once the target temperature was reached, the temperature was maintained for a predetermined dwell time. After the dwell time, the furnace was allowed to cool naturally. After cooling, the wafers were removed from the furnace and their visual appearance was observed qualitatively and recorded. X-ray diffraction analysis confirmed the original crystal structure of the material. The preconditioned wafers were subjected to the same hot plate treatment described in the Comparative Example to ascertain the surface charge of the wafers after being exposed to a temperature change and the charge decay time required for the surface charge to fall below the 5x10⁻¹¹ coulomb lower detection limit of the electrostatic field meter. For those wafers where the target temperature was set at 500°C or greater and the wafer wherein the target temperature was 400°C and the dwell time was 200 minutes, the surface charge measured immediately before, during and after completion of cooling to 80°C was below the detection limit of the electrostatic field meter. From this observation, it was presumed that the charge had decayed in less than 1 second. The surface resistivity of the wafers was determined using a Keithley Instruments Model 487 picoammeter/voltage source together with a Model 8008 resistivity test fixture. The surface resistivity was measured by applying a voltage of 200 volts across the circular gap between the two electrodes. The electrodes were circular (one larger doughnut-shaped electrode, and a smaller circular-shaped one located within the larger electrode) and were contacted to the polished wafer surface using conductive rubber. The "effective perimeter" of the circular electrode was 16.97 centimeters (6.68 inches) and the gap width was 0.32 centimeters (1/8 of an inch). The surface resistivity Σ is given by 6.68/0.25 x U/I = 53.4 x U/I, where U is the 200 volts applied, and I was the current across the gap read about one minute after applying the voltage, when the display was stable. The results are summarized in Table 1.

**Table 1**

| Furnace Target Temperature (°C) | Dwell Time (minutes) | Color | Surface Charge (coulombs) | Surface Resistivity (ohms) | Charge Decay Time at 80°C (hrs) |
|---|---|---|---|---|---|
| 80°C (Comparative Example) | - | colorless/ translucent | 5.0 E⁻⁹ | - | 16+ |
| 400 | 1 | very light grey-colorless/ translucent | 5.0 E⁻⁹ | 9.11E+13 | 16+ |
| 400 | 200 | grey/translucent | <5.0 E⁻¹¹ | - | <1 sec |
| 500 | 1 | grey/translucent | <5.0 E⁻¹¹ | 1.2E+14 | <1 sec |
| 550 | 1 | grey/translucent | <5.0 E⁻¹¹ | - | <1 sec |
| 650 | 1 | dark grey/ translucent | <5.0 E⁻¹¹ | 1.8E+12 | <1 sec |
| 700 | 1 | black/opaque | <5.0 E⁻¹¹ | - | <1 sec |
| 750 | 1 | black/opaque | <5.0 E⁻¹¹ | 2.1E+10 | <1 sec |
| 800 | 1 | black/opaque | <5.0 E⁻¹¹ | 6.4E+10 | <1 sec |
| 1030 | 1 | black/opaque | <5.0 E⁻¹¹ | 1.7E+8 | <1 sec |

This example illustrates how preconditioned LN crystal wafers of the present invention effectively reduce charging of the surface of an LN crystal wafer.

It is believed that the concepts of the present invention can easily be applied to various LN or LT crystals having a wide variety of physical characteristics, such as wafers of varying diameters, thicknesses and orientations. This can be accomplished by selecting appropriate furnace temperatures, dwell times, chemically reducing atmospheres and other parameters. The concepts of the present invention could also be applied to wafers either before or after the wafers have been polished, or even to slabs of crystal material. In addition, the method of the present invention may be performed at different stages of the manufacturing of devices, such as after cleaning or metal deposition on the wafers.

The advantages provided by preconditioned crystals of the present invention and the method of preconditioning crystals in accordance with the present invention are applicable to LN and LT crystals that are subjected to manufacturing conditions that invoke either a pyroelectric or piezoelectric response that results in the buildup of unwanted surface charges. The ability of crystals preconditioned in accordance with the present invention to reduce the build up of surface charges is not believed to adversely affect the ability of the crystal to perform in its intended manner. For instance, for SAW based devices, the frequency of the mechanical stress encountered in normal operation and the resulting response is high enough that any increase in the rate of dissipation of the surface charge build resulting from preconditioning the crystal in accordance with the present invention does not affect the performance of the device incorporating the crystal. On the other hand, the preconditioned crystals of the present invention are able to effectively reduce the unwanted surface charge buildup resulting from temperature changes or mechanical stresses originating from the process of manufacturing the device in which the crystal is incorporated, or occurring during use of the device, because the frequency of the mechanical stress or temperature change is much less than the frequency encountered in normal operation.

## Claims

1. A method for preconditioning a lithium niobate or lithium tantalate crystal to increase the crystal's ability to reduce electric charging of the crystal surface comprising:
heating the crystal under a chemically reducing atmosphere to a first temperature; andcooling the crystal to below a second temperature under the chemically reducing atmosphere;
wherein the chemically reducing atmosphere, the first temperature and the second temperature are selected so that following heating and cooling, a charge decay time of less than one second is required to reduce the surface charge of the crystal to less than 5.0 x 10⁻¹¹ coulombs as measured at a temperature of 80° C following heating to a temperature of 125 ° C.

2. The method of Claim 1, wherein thefirst temperature is greater than about 500° C.

3. The method of Claim 1, wherein the first temperature is a temperature in the range between about 500° C and about 1,140° C.

4. The method of Claim 1, wherein the chemically reducing atmosphere comprises gases selected from argon, hydrogen, nitrogen, carbon monoxide, and combinations thereof.

## Patentansprüche

1. Verfahren zum Vorkonditionieren eines Lithiumniobatoder Lithiumtantalatkristalls, um die Fähigkeit des Kristalls zu verstärken, elektrische Aufladung der Kristalloberfläche zu reduzieren, bei dem
der Kristall unter einer chemisch reduzierenden Atmosphäre auf eine erste Temperatur erwärmt wird; und der Kristall unter der chemisch reduzierenden Atmosphäre auf unter eine zweite Temperatur abgekühlt wird;
wobei die chemisch reduzierende Atmosphäre, die erste Temperatur und die zweite Temperatur so gewählt werden, dass nach dem Erwärmen und Abkühlen eine Ladungsabklingzeit von weniger als einer Sekunde erforderlich ist, um die Oberflächenladung des Kristalls auf weniger als 5,0 x 10⁻¹¹ Coulomb zu reduzieren, gemessen bei einer Temperatur von 80 °C nach Erwärmen auf eine Temperatur von 125 °C.

2. Verfahren nach Anspruch 1, wobei die erste Temperatur größer als etwa 500 °C ist.

3. Verfahren nach Anspruch 1, wobei die erste Temperatur eine Temperatur im Bereich zwischen etwa 500 °C und etwa 1140 °C ist.

4. Verfahren nach Anspruch 1, wobei die chemisch reduzierende Atmosphäre Gase ausgewählt aus Argon, Wasserstoff, Stickstoff, Kohlenmonoxid und Kombinationen davon umfasst.

## Revendications

1. Procédé pour préconditionner un niobate de lithium ou un tantalate de lithium cristallin pour augmenter la capacité du cristal à réduire la charge électrique de la surface du cristal comprenant :
le chauffage du cristal sous une atmosphère chimiquement réductrice à une première température ; et le refroidissement du cristal en dessous d'une deuxième température sous l'atmosphère chimiquement réductrice ;
dans lequel on choisit l'atmosphère chimiquement réductrice, la première température et la deuxième température de telle façon qu'à la suite du chauffage et du refroidissement, un temps de chute de charge inférieure à une seconde est nécessaire pour réduire la charge de surface du cristal à moins de 5,0 x 10⁻¹¹ coulombs comme on le mesure à une température de 80 °C suivant le chauffage à une température de 125 °C.

2. Procédé selon la revendication 1, dans lequel la première température est supérieure à 500 °C environ.

3. Procédé selon la revendication 1, dans lequel la première température est une température dans la gamme de 500 °C environ à 1140 °C environ.

4. Procédé selon la revendication 1, dans lequel l'atmosphère chimiquement réductrice est constituée d'un gaz choisi parmi l'argon, l'hydrogène, l'azote, le monoxyde de carbone et leurs combinaisons.
